# EUROPEAN PATENT APPLICATION

(11) **EP 1 860 373 A1**
(43) Date of publication of application: **28.11.2007**
(21) Application number: 05820178.1
(22) Date of filing: 26.12.2005
(51) Int. Cl.: F21V 8/00, G02F 1/13357, H01L 33/00, F21Y 101/02

(54) **PLANAR ILLUMINATION DEVICE**

(30) Priority: 18.02.2005 JP 2005041599
(71) Applicant: MINEBEA Co., Ltd., Kitasaku-gun, Nagano-Ken 389-0293 (JP)
(72) Inventor: Suzuki, shingo c/o Minebea Co., Ltd., Kitasaku-gun Nagano 3890293 (JP); Nakayama, daisuke c/o Minebea Co., Ltd., Kitasaku-gun Nagano 3890293 (JP)
(74) Representative: Schaad, Balass, Menzl & Partner AG
(86) International application number: PCT/JP2005/023765
(87) International publication number: WO 2006/087872

(57) **Abstract**

[PROBLEMS] A planar illumination device using an LED is further increased and uniformized in brightness and is further thinned. [MEANS FOR SOLVING PROBLEMS] An LED (24) of a planar illumination device has no lamp house, and in the planar illumination device, a translucent resin (26) for sealing an LED chip (25) is exposed. As a consequence, the thickness of the planar illumination device is smaller by the amount of the thickness of the lamp house. In addition, because the outer shape of the translucent resin satisfies 0.3 = H/R = 0.6, a ratio of the amount of forwardly emitted light of the LED that contribute to higher brightness of the planar illumination device and a half bandwidth of the LED that contributes to brightness uniformization of the planar illumination device can be balanced at a high level. Further, because the radius R of a projection (28) of the LED (24) is formed to satisfy 1.5X = R, the LED chip (25) is completely sealed in the translucent resin (26) without being exposed from the translucent resin (26).

## Description

### Technical Field

The present invention relates to a side-light type planar illumination device and particularly to a planar illumination device used as illuminating means of a liquid crystal display device.

### Background Art

Liquid crystal display devices are widely used in display means or the like of electronic equipment at present but since liquid crystal display devices are not self-luminous, illuminating means for ensuring visibility at night and in dark places are needed. A planar illumination device has been used as such illuminating means.

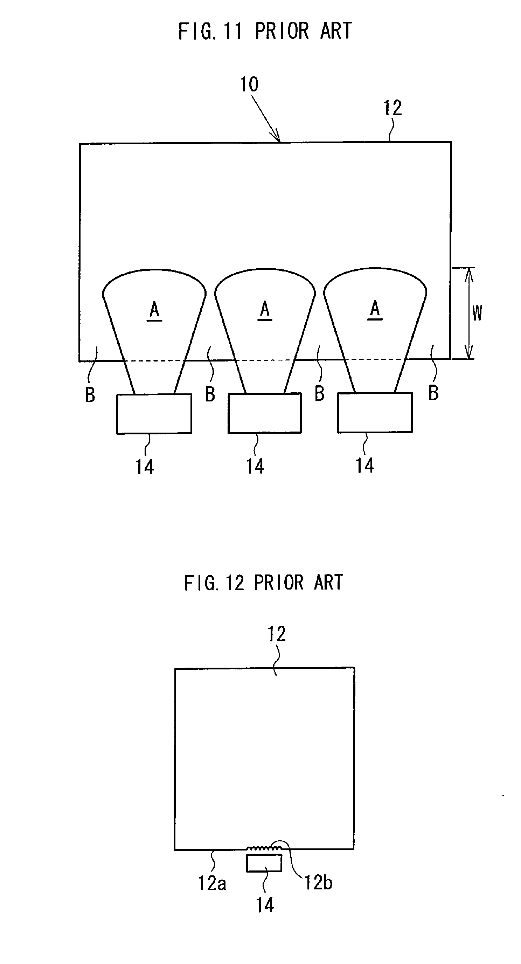

As one type of such a planar illumination device, a side-light type planar illumination device is widely used. Such a side-light type planar illumination device comprises a light guide plate with light transmittance, a rod-state light source arranged on a side end face of the light guide plate or one or more point-like light sources as basic elements. As a recent trend, in accordance with an increased number of applications to small-sized electronic equipment such as personal digital assistants, a planar illumination device of a type provided with a point-like light source capable of having a simplified driving circuit is used. Fig. 11 schematically shows a light guide plate 12 and a plurality of point-like light sources (LED) 14 arranged on a side end face of the light guide plate 12 in a side-light type planar illumination device 10.

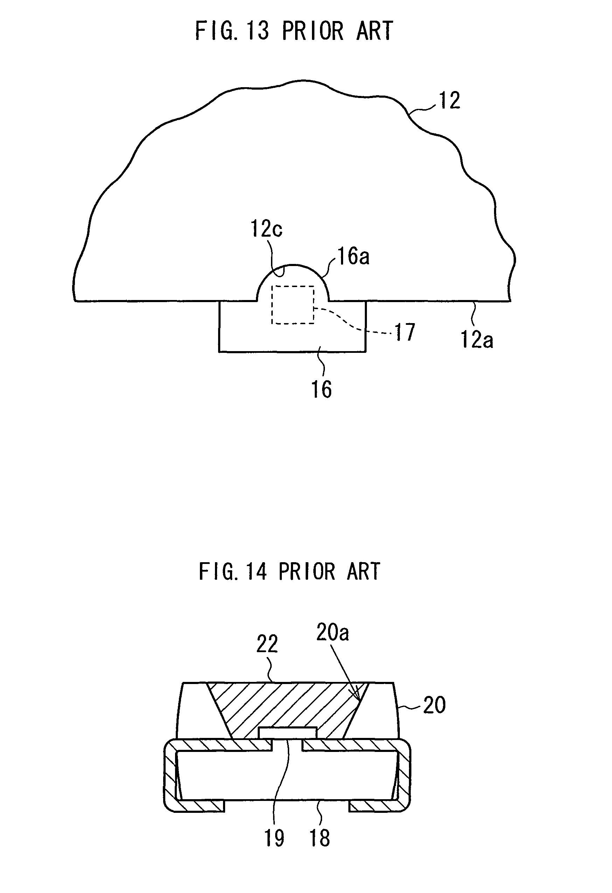

In the planar illumination device 10 using the point-like light source 14 shown in Fig. 11, since light irradiated from the LED 14 to the light guide plate 12 has a given directivity, the vicinity of the LED 14 of the light guide plate 12 illuminated by the LED 14 is clearly divided into a bright part A and a dark part B. As a measure for solving a problem of this difference between the bright part and the dark part so as to obtain average brightness, an optical diffused reflection pattern 12b such as a fine prism row is provided on an opposite face 12a opposite the LED 14 of the light guide plate 12 as shown in Fig. 12, an LED 16 in which a part of an armor member is made into a projecting portion 16a in a half-column state is used and a semi-cylindrical recess portion 12c to be fitted with the projecting portion 16a is provided at the light guide plate 12 so as to emit light of an LED chip 17 radially from a slit formed at the projecting portion 16a (See Patent Document 1, for example) as shown in Fig. 13, or moreover, a lamp house 20 covering an LED chip 19 is provided as in an LED 18 shown in Fig. 14 so as to control light directivity by changing a height of the lamp house 20 or an inclination angle of an inclined face 20a (See Patent Document 2, for example). In Fig. 14, reference numeral 22 denotes a translucent resin for sealing the LED chip 19 in the lamp house 20.
Patent Document 1: Japanese Unexamined Patent Application Publication No. 10-199316 ([0023], [0026] to [0028])
Patent Document 2: Japanese Unexamined Patent Application Publication No. 2002-217459 (Claim 1, Fig. 1)

### Disclosure of Invention

### Problems to be Solved by the Invention

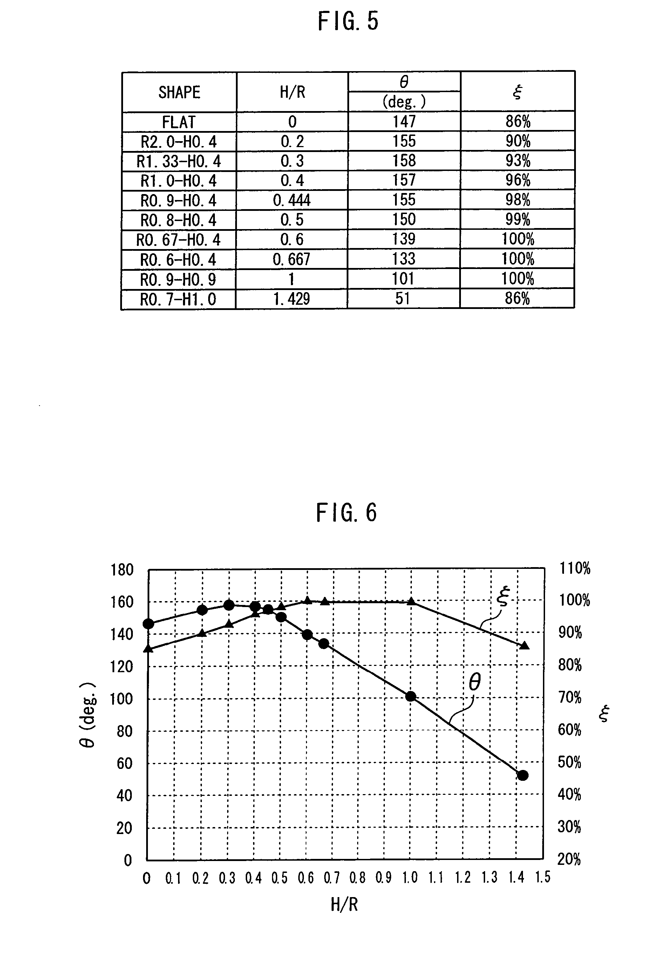

Since the planar illumination device using the above LED has a role as illuminating means of a liquid crystal display device, further reduction in the thickness is in demand all the time while promoting higher and more uniform brightness. In this regard, in the planar illumination device using the LED 14 whose front light emitting face is flat as shown in Fig. 12, many beams in the light emitted from the LED chip sealed inside the LED are fully reflected by the front flat face, and since the forward outgoing light amount ratio is deteriorated (See Fig. 5) as will be described later, there is a limitation in promotion of high brightness. Also, in the planar illumination device using the LED 16 of the type that light is emitted from the half-column projecting portion 16a as shown in Fig. 13, the light beams fully reflected by the light emitting face is decreased, and as will be described later, the forward outgoing light amount ratio is improved (See Fig. 5) but on the contrary, a half width of the LED is narrowed by a lens effect (See Fig. 5), which leads to a problem that uniform brightness can not be realized. On the other hand, as shown in Fig. 14, in the planar illumination device using the LED 18 provided with the lamp house 20 covering the LED chip 19, the thickness of the lamp house 20 causes an obstacle to thinning of the planar illumination device.

The present invention was made in view of the above problems and has an object to further reduce the thickness of the planar illumination device using the LED while promoting higher and more uniform brightness.

### Means for Solving the Problems

In order to solve the above problems, the planar illumination device according to the present invention comprising a plate-like light guide plate and an LED arranged on a side end face of the light guide plate is configured so that the LED has no lamp house, a translucent resin that seals an LED chip is exposed, an outline of the translucent resin comprises a continuous curved surface projecting to the front in the light emitting direction of the LED, and a value obtained by dividing the projecting height by the radius of the continuous curved surface is in a range of 0.3 or more and 0.6 or less.

According to the present invention, since the LED has no lamp house but the translucent resin that seals the LED chip is exposed, increase by the thickness of the lamp house is not generated but reduction in the thickness of the planar illumination device is promoted. Moreover, since the outline of the translucent resin has the above predetermined shape, the forward outgoing light amount ratio of the LED contributing to higher brightness of the planar illumination device and an angle of the outgoing light of the LED contributing to more uniform brightness of the planar illumination device can be balanced at a higher dimension.

Also, in the present invention, the radius of the projecting portion comprising the continuous curved surface is preferably formed having a value obtained by multiplying the length when the LED chip is projected in a direction crossing the light guide plate by 1.5 or more.

According to the present invention, the LED chip is fully sealed in the translucent resin while the outline of the translucent resin is provided with the above predetermined shape.

Also, by forming a notch portion following the outline of the projecting portion on the side end face opposed to the LED, the translucent resin of the LED having the above predetermined outline shape and the light guide plate are brought into close contact with each other, light emission distribution of the light incident to the light guide plate from the LED can be made equivalent to the light emission distribution of the light by a single LED, which can contribute to more uniform brightness of the planar illumination device.

In the meantime, the projecting portion comprising the continuous curved surface is formed integrally with the base portion made of a rectangular solid translucent resin which is long in a direction parallel with the side end face of the light guide plate and short in a direction crossing the light guide plate, and the projecting height of the projecting portion may be the projecting height from the base portion.

In this case, when a notch portion following the outline of the projecting portion and the base portion is formed on the side end face opposed to the LED of the light guide plate, both the projecting portion and the base portion of the translucent resin are brought into close contact with the light guide plate, and the light emission distribution of the light incident to the light guide plate from the LED can be made equivalent to the light emission distribution of the light by a single LED, which contributes to more uniform brightness of the planar illumination device. Also, not only the outgoing light from the projecting portion but also the outgoing light from the base portion can be entered into the light guide plate so as to contribute to higher brightness of the planar illumination device.

Moreover, by reflecting a reflector along the side face of the LED in a direction parallel with the light guide plate, most of leaking light emitted from other than the front of the LED can be guided to the light guide plate.

### Advantages of the Invention

Since the present invention is comprised as above, thinning of the planar illumination device using the LED can be further accelerated while promoting higher and more uniform brightness.

### Brief Description of the Drawings

Fig. 1 is a diagram schematically showing an outline of a translucent resin that seals an LED chip of an LED in a planar illumination device according to an embodiment of the present invention.
Fig. 2 is a perspective view of an appearance illustrating a specific structural example of the LED shown in Fig. 1.
Fig. 3 is a sectional view illustrating a specific structural example of the LED shown in Fig. 1.
Figs. 4 are views illustrating the LED chip sealed in the LED shown in Fig. 1, in which Fig. 4(a) is a plan view and Fig. 4(b) is a side view.
Fig. 5 is a chart of a half width θ indicating an angle of outgoing light and a forward outgoing light amount ratio ξ.
Fig. 6 is a graph based on the values in Fig. 5.
Fig. 7 is an explanatory diagram for explaining the half width in Figs. 5, 6.
Fig. 8 is a perspective view illustrating an example in which a notch portion following an outline of a projecting portion of the LED is formed on the side end face opposed to the LED of the light guide plate in the planar illumination device according to the embodiment of the present invention.
Figs. 9 are perspective views illustrating an example where the notch portion following the outline of the projecting portion and the base portion of the LED is formed on the side end face opposed to the LED of the light guide plate in the planar illumination device according to the embodiment of the present invention, in which Fig. 9(a) is an exploded view and Fig. 9(b) is a connected view.
Figs. 10 are perspective views illustrating an example where a reflector is arranged along a side face of the LED in a direction parallel with the light guide plate in the planar illumination device according to the embodiment of the present invention, in which Fig. 10(a) is an exploded view and Fig. 10(b) is a connected view.
Fig. 11 is a plan view illustrating basic configuration of a conventional planar illumination device using an LED.
Fig. 12 is a plan view illustrating a conventional planar illumination device for which a measure to obtain average brightness is taken.
Fig. 13 is a plan view illustrating a conventional planar illumination device for which a measure to obtain average brightness is taken.
Fig. 14 is a plan view illustrating an LED for which a measure to obtain average brightness is taken.

### Reference Numerals

10 Planar illumination device
12 Light guide plate
12a Side end face opposed to LED
24 LED
24a, 24b Side face in direction parallel with light guide plate
25 LED chip
26 Translucent resin
28 Projecting portion
29 Base portion
30 YAG particle mixed layer
32 Transparent layer
36 Reflector

### Best Mode for Carrying Out the Invention

Embodiments of the present invention will be described below with reference to the attached drawings. Here, portions equivalent to or corresponding to the prior art are shown by the same reference numerals and detailed description thereof will be omitted.

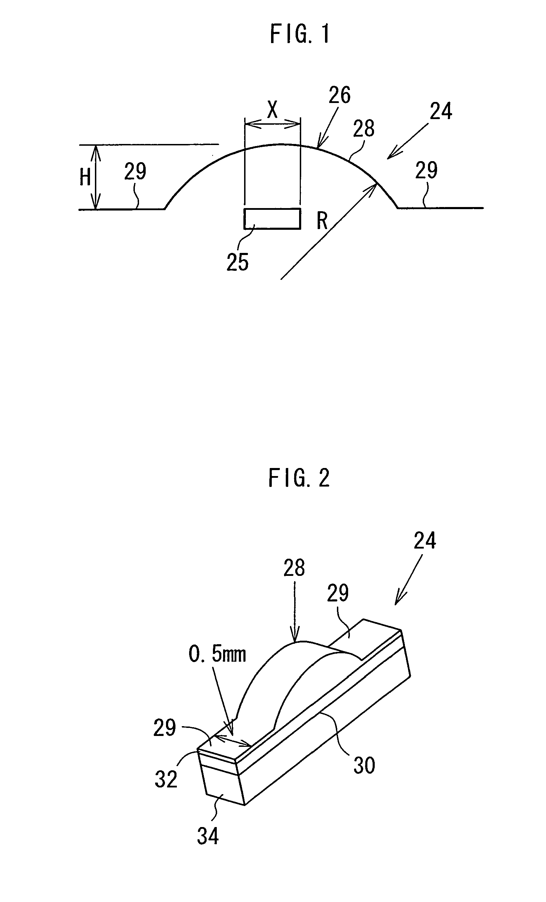

A planar illumination device according to an embodiment of the present invention comprises, similar to a known planar illumination device shown in Fig. 11, a plate-like light guide plate and an LED arranged on a side end face of the light guide plate. An LED 24 to be used does not have a lamp house as shown in Figs. 1 to 3 but has a structure in which a translucent resin 26 that seals an LED chip 25 is exposed. An outline of the translucent resin 26 has a projecting portion 28 comprising a continuous curved surface projecting to the front in a light emitting direction of the LED 24. In the shown example, the projecting portion 28 is formed integrally with a base portion 29 comprising a rectangular solid translucent resin, which is long in a direction parallel with the light guide plate (direction parallel with the surface of the figure of the light guide plate 12 shown in Fig. 11) and short in a direction crossing the light guide plate (direction crossing the surface of the figure of the light guide plate 12 shown in Fig. 11).

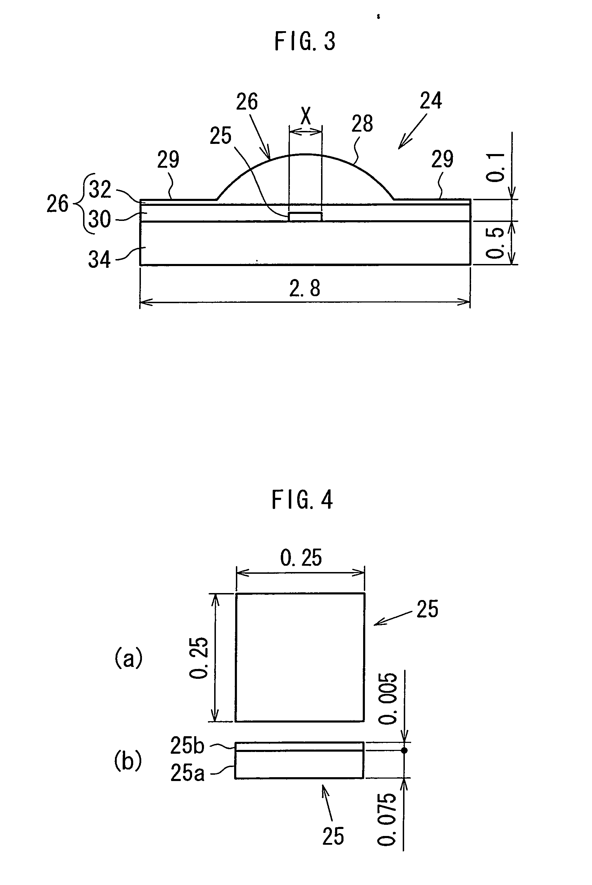

In this embodiment, when the projecting height (projecting height from the base portion 29) of the projecting portion 28 is H, the continuous curved surface constituting the projecting portion 28 is formed in a range of 0.3 ≤ H/R ≤ 0.6, or preferably in a range of 0.4 ≤ H/R ≤ 0.5. Also, the radius of the projecting portion 28 is formed to have a value obtained by multiplying a length when the LED chip 25 is projected in a direction crossing the light guide plate (length in a direction parallel with the longitudinal direction of the LED 24 and indicated by reference symbol X in Figs. 1 and 3) by 1.5 or more (1.5X ≤ R).

The structure of the LED 24 is shown in more detail in Figs. 2 and 3, in which the translucent resin 26 has a structure in which the periphery of the LED chip 25 is sealed by a layer 30 in which yttrium, aluminum, garnet (YAG) particles activated by cerium, which is a yellow luminescent material, are mixed in a hard silicon resin, and a transparent hard silicon resin layer 32 is further added on its periphery (upper layer). Therefore, in the shown example, the projecting portion 28 is formed on the transparent hard silicon resin layer 32. Also, as the LED chip 25, as shown in Fig. 4, a light emitting layer 25b made of a lamination of a nitride compound semiconductor such as GaN, GaAIN and the like on a sapphire substrate 25a is formed (blue luminescent device) is used. In addition, the LED chip 25 is, as shown in Fig. 3, bonded onto a substrate (PCB) 34 having an electrode portion, and anode and cathode electrodes and a wiring pattern on the substrate 34 formed on the LED chip 25 have a structure connected by a gold line of Φ20 µm. Figs. 2 to 4 show a specific dimensional example of the LED 24 and the LED chip 25 (in units of mm).

In the LED 24 having the above structure, since a part of blue light emission of the LED chip 25 is absorbed by the YAG particles (luminescent body) of the YAG particle mixed layer 30 and converted to a wavelength longer than that of the light emission of the LED chip 25 so as to generate color mixture with the blue light luminescence of the LED chip 25, which emits a quasi white light. The YAG particle mixed layer 30 of the translucent resin 26 is not limited to the configuration fully separated from the transparent layer 32 into two layers as shown in Figs. 2 and 3, but such a structure can be employed in which the YAG particle mixed layer 30 is formed only on the periphery of at least the blue light emitting LED chip 25 and its periphery is entirely covered by the transparent layer 32.

It is only necessary for the translucent resin 26 to be a transparent resin having heat resistance and a thermosetting transparent resin such as a transparent epoxy resin, for example, can be applied rather than the above hard silicon resin. A thermoplastic resin with high heat resistance and an inorganic material such as glass can be also applied as necessary.

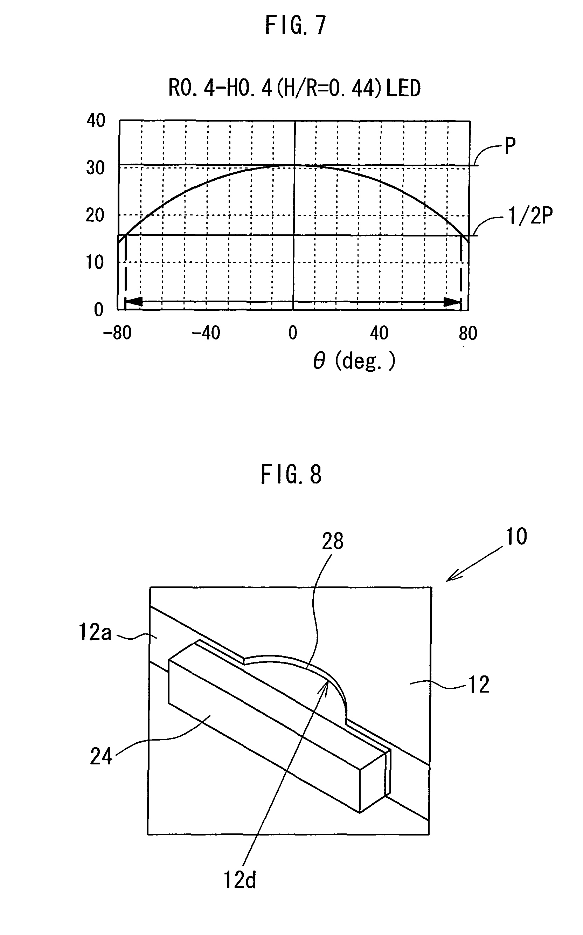

Fig. 5 is a chart showing changes of a half width θ indicating an angle of outgoing light of the LED and forward outgoing light amount ratio ξ by varying the value of H/R of the LED 24 used in the planar illumination device according to the embodiment of the present invention. Fig. 6 is a graph based on the values in Fig. 5. With regard to the "half width θ", as shown in Fig. 7, an angle of outgoing light when an outgoing intensity 1/2P can be obtained, which is half peak value P of the intensity of the outgoing light (normally it appears in the vicinity of θ = 0°, which is a front direction of the LED 24), is referred to as the "half width" and this is a value generally used as an index of outgoing light distribution. Fig. 7 exemplifies the half width θ of the LED with R = 0.9 mm, H = 0.4 mm and H/R = 0.44.

Also, with regard to the "forward outgoing light amount ratio ξ", when light in all the directions emitted from the LED is classified into light contributing to higher brightness of the planar illumination device emitted to the front of the LED (including spaces above and below) and light not contributing to higher brightness of the planar illumination device emitted to the rear of the LED (including the spaces above and below), the "forward outgoing light amount ratio ξ" is a value indicating a ratio of the former.

As is obvious from these specific numeral examples, in the range of 0.3 ≤ H/R ≤ 0.6, sufficiently favorable values are obtained both for the half width θ and the forward outgoing light amount ratio ξ. Also, for a balance at a higher level between the half width θ and the forward outgoing light amount ratio ξ in order to realize higher and more uniform brightness of the planar illumination device, the range of 0.4 ≤ H/R ≤ 0.5 is preferable. In the case of H/R = 0 (LED 14 with the front light emitting face in the flat shape as shown in Fig. 12), the value of the forward outgoing light amount ratio ξ drops to the lowest level, and it is understood that higher brightness of the planar illumination device can not be satisfactorily realized. On the other hand, in the case of H/R = 1 (LED 16 of the type emitting light from a half-columnar projecting portion 16a as shown in Fig. 13), the value of the half width θ is greatly lowered, and it is understood that obtaining uniform brightness of the planar illumination device is difficult.

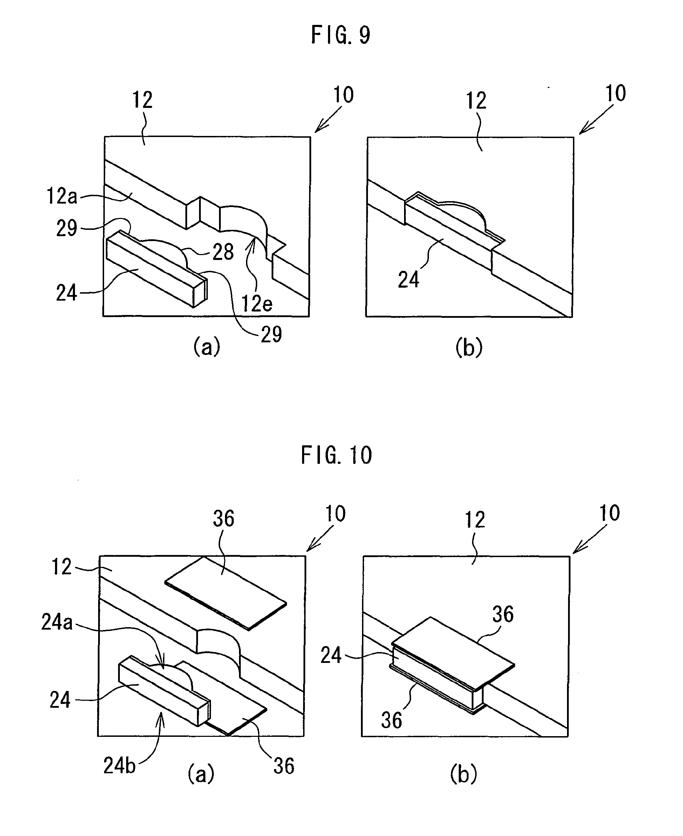

In the planar illumination device according to the embodiment of the present invention, the notch portion 12d following the outline of the projecting portion 28 may be formed on the side end face 12a opposed to the LED 24 of the light guide plate 12 so that the projecting portion 28 of the LED 24 is fitted in the notch portion 12d as shown in Fig. 8. Alternatively, a notch portion 12e following the outlines of the projecting portion 28 and the base portion 29 of the LED 24 may be formed on the side end face 12a opposed to the LED 24 of the light guide plate 24 as shown in Fig. 9(a) and the projecting portion 28 and the base portion 29 of the LED 24 may be fitted in the notch portion 12e as shown in Fig. 9(b).

Moreover, as shown in Figs. 10(a) and 10(b), a reflector 36 may be arranged along side faces 24a, 24b of the LED 24 in a direction parallel with the light guide plate 12 (upper and lower faces in the example shown in Figs. 10). As the reflector 36, a reflector in which a metal thin film with high reflectivity such as aluminum, silver and the like is formed on a thin resin substrate is preferable in terms of slimness and reflection characteristics but a reflector with high optical reflectivity formed by applying a white or milky white paint on a thin resin base, and a white resin board made of a resin mixed with a white pigment, or a metal thin plate with high reflectivity such as aluminum, silver and the like may be used. Also, by keeping the thickness at 100 µm or less, the thickness of the entire planar illumination device 10 can be kept as small as possible. Also, the shape of the reflector 36 is preferably a rectangle which can fully cover the entire LED 24 as shown in the figure, when considering productivity, but the shape covering only the projecting portion 28 of the LED 24, for example, can obtain a necessary effect.

According to the embodiment of the present invention formed as above, the following actions and effects can be obtained. First, since the LED 24 constituting the planar illumination device has no lamp house and the translucent resin 26 that seals the LED chip 25 is exposed, increase of the thickness for the lamp house is not generated and thinning of the planar illumination device is possible. Moreover, since the outline of the translucent resin has the shape satisfying 0.3 ≤ H/R ≤ 0.6, forward outgoing light amount ratio ξ of the LED contributing to higher brightness of the planar illumination device and the half width θ of the LED contributing more uniform brightness of the planar illumination device can be balanced to a high degree.

Also, since the radius R of the projecting portion 28 of the LED 24 is formed to satisfy 1.5X ≤ R, the LED chip 25 is not exposed from the translucent resin 26 but fully sealed in the translucent resin 26. Thus, yield of the LED 24 can be improved with certainty and costs for the planar illumination device can be reduced.

By forming the notch portion 12d following the outline of the projecting portion 28 on the side end face 12a opposed to the LED 24 of the light guide plate 12, the translucent resin 26 of the LED 24 and the light guide plate 12 are brought into close contact with each other, the light emission distribution of the light incident to the light guide plate from the LED 24 can be made equivalent to the light emission distribution of the light by a single LED, which can further contribute to more uniform brightness of the planar illumination device. Moreover, by forming the notch portion 12e following the outlines of the projecting portion 28 and the base portion 29 on the side end face 12a opposed to the LED 24 of the light guide plate 12, both the projection portion 28 and the base portion 29 of the translucent resin 26 are brought into close contact with the light guide plate 12, and not only the outgoing light from the projecting portion 28 but also the outgoing light from the base portion 29 enter the light guide plate 12, which can further contribute to higher and more uniform brightness of the planar illumination device.

The LED 24 shown in Figs. 1 to 3 and Figs. 8 to 10 has the shape in which the projecting portion 28 and the base portion 29 are integrally formed, but this shape is used so that the base portion 29 functions as a supply path of resin to each LED when such a manufacturing process is employed such that a plurality of LEDs 24 are integrally formed in front and rear as well as right and left and then, cut into single LEDs. Thus, the LED shape having the base portion 29 is preferable in terms of improving production efficiency of the LED 24. On the other hand, since contribution of the base portion 29 to higher and more uniform brightness of the planar illumination device is smaller than that of the projecting portion 28, the same effect as above can be obtained by constructing the outline of the translucent resin 26 of the LED 24 only from the projecting portion 28. As shown in Fig. 1, the LED 24 is formed so that a base end portion of a continuous curved surface constituting the projecting portion 28 substantially matches the upper end face of the LED chip 25, and the projecting height H of the projecting portion 28 when the base portion 29 is provided is the projecting height from the base portion 29. On the other hand, the projecting height H of the projecting portion 28 when the base portion 29 is not provided is the projecting height from the upper end face of the LED chip 25 (See Fig. 1).

The continuous curved surface constituting the projecting portion 28 of the LED 24 preferably has a given radius R as shown in the figure from the viewpoint of productivity, but the above actions and effects can be also obtained by constituting the projection portion 28 with a spherical surface having a given radius or by gradually changing the radius R from the top of the projecting portion 28 toward the base portion 29.

Moreover, since the reflector 36 is arranged along the side faces 24a, 24b of the LED 24 in the direction parallel with the light guide plate 12, much of the leaking light emitted from regions other than the front of the LED 24 can be guided to the light guide plate 12 so that the above effects become further marked.

The planar illumination device according to the embodiment of the present invention can be also applied to a so-called back light and front light.

## Claims

1. A planar illumination device provided with a plate-like light guide plate and an LED arranged on a side end face of the light guide plate, **characterized in that** the LED has no lamp house, a translucent resin that seals an LED chip is exposed, an outline of the translucent resin comprises a continuous curved surface projecting to the front in a light emitting direction of the LED, and a value obtained by dividing the projecting height by a radius of the continuous curved surface is in a range of 0.3 or more and 0.6 or less.

2. The planar illumination device according to claim 1, wherein the radius of the projecting portion comprising the continuous curved surface is formed so as to have a value obtained by multiplying a length when the LED chip is projected in a direction crossing the light guide plate by 1.5 or more.

3. The planar illumination device according to claim 1 or 2, wherein a notch portion following the outline of the projecting portion is formed on the side end face opposed to the LED.

4. The planar illumination device according to claim 1 or 2, wherein the projecting portion comprising the continuous curved surface is formed integrally with a base portion made of a rectangular solid translucent resin which is long in a direction parallel with the side end face of the light guide plate and short in a direction crossing the light guide plate, and the projecting height of the projecting portion is the projecting height from the base portion.

5. The planar illumination device according to claim 4, wherein a notch portion following the outlines of the projecting portion and the base portion is formed on the side end face opposed to the LED.

6. The planar illumination device according to any one of claims 1 to 5, wherein a reflector is arranged along a side face of the LED in a direction parallel with the light guide plate.
